# EUROPEAN PATENT APPLICATION

(11) **EP 0 913 863 A2**
(43) Date of publication of application: **06.05.1999**
(21) Application number: 98119950.8
(22) Date of filing: 21.10.1998
(51) Int. Cl.: H01L 23/485

(54) **Method of manufacturing semiconductor device with copper wiring film**

(30) Priority: 31.10.1997 JP 316089/97
(71) Applicant: NEC CORPORATION, Tokyo (JP)
(72) Inventor: Onishi, Hideaki, Tokyo (JP)
(74) Representative: Glawe, Delfs, Moll & Partner

(57) **Abstract**

In a method of manufacturing a semiconductor device, a copper wiring film is formed in an interlayer insulating film by a damascene method. A protective insulating film is formed on the copper wiring film and the interlayer insulating film. Then, an opening is formed in the protective insulating film. Subsequently, an Al containing film is deposited on the protective insulating film to fill the opening. In this case, the Al containing film may be patterned. Instead, a CMP (chemical mechanical polishing) method may be performed to the Al containing film to embed the Al containing film in the opening.

## Description

### Background of the Invention

### 1. Field of the Invention

The present invention relates to a manufacturing method of a semiconductor device and, more particularly, to a manufacturing method of a semiconductor device using a copper wiring film.

### 2. Description of the Related Art

In association with the realization of fine patterning of an LSI, the resistance of a wiring film increases. For this reason, a delay time in an LSI due to wiring films is relatively increasing as compared with a delay time due to a circuit element. An electric potential drop in a power source line occurs and a delay deviation of a clock signal causes an erroneous operation. A density of a current flowing in the wiring film also increases and the reliability of the wiring film is decreased for a disconnection due to an electromigration. In devices after the subquarter micron generation, therefore, a new wiring material is demanded in place of an aluminum (Al) wiring film which has conventionally been used.

At present, a copper wiring film is promised as the new wiring material after the subquarter micron generation, since copper has a low resistivity and a high electromigration resistance.

As a typical method of realizing the copper wiring film, a groove wiring method (damascene method) is used in which grooves are formed on an interlayer insulating film and wiring films are formed by using a chemical mechanical polishing (CMP) method.

As another method, there is a method of forming wiring films by a dry etching method which has hitherto been used. In this method, because a vapor pressure of halide of copper is very low, it is very difficult to perform a dry etching. Also, severe step coating performance is required in the formation of an interlayer insulating film after the etching. For these reasons, the damascene method is promised as a method of realizing such copper wiring films. The damascene method is described in "Ultra-Low Resistance Direct Contact Cu Via Technology Using In-situ Chemical Vapor Cleaning" by Y. Tsuchiya et al., (1997 Symposium on VLSI Technology Digest of Technical Papers, pp. 59 - 60).

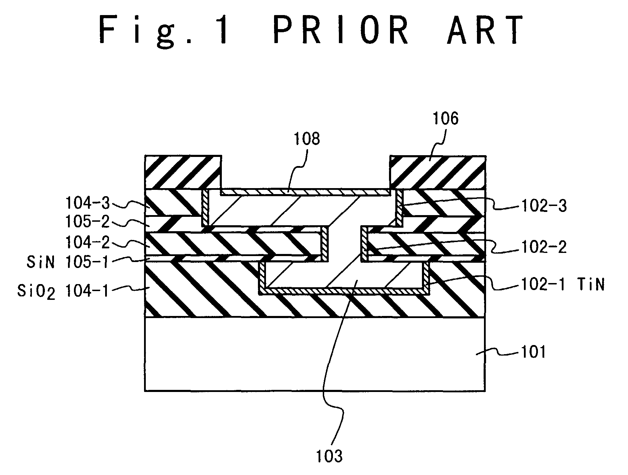

A case where a protective insulating film is formed and a bonding pad region is opened is shown in Fig. 1. Referring to Fig. 1, reference numeral 101 denotes a Si substrate; 102 (102-1, 102-2 and 102-3) TiN films functioning as a barrier film to prevent diffusion of copper atoms and to improve fitness; 103 a copper wiring film; 104 (104-1, 104-2 and 104-3) SiO₂ films functioning as an interlayer insulating film; 105 (105-1 and 105-2) SiN films functioning as a barrier insulating film to prevent the diffusion of copper atoms; 6 a protective insulating film (it is desirable to use SiN); and 8 a copper oxide layer.

The damascene method is a method in which after grooves are formed, the copper film 103 is deposited by a CVD (Chemical Vapor Deposition) method, a plating method, or the like. After that, the copper film 103 is polished by the CMP method with the interlayer insulating films each serving as a stopper. Thus, the excessive copper film is removed from the regions other than the wiring region. Therefore, it is difficult to form a barrier metal film on the surface of the copper wiring film. If the bonding pad portion is opened after the protective insulating films 106 is formed, the copper wiring film 103 is exposed.

The foregoing conventional damascene method has the following problems. That is, in particular, the copper wiring film is easily oxidized in an etching for the formation of the opening portion in the interlayer insulating film or a peeling step of a photo-resist, so that a copper oxide film 108 is formed in the bonding pad portion as shown in Fig. 1.

If the wire bonding is performed in such a state for assembly of the LSI, many defective bonding portions are produced since fitness is weak between the copper oxide film 108 and the bonding wire of gold or the like.

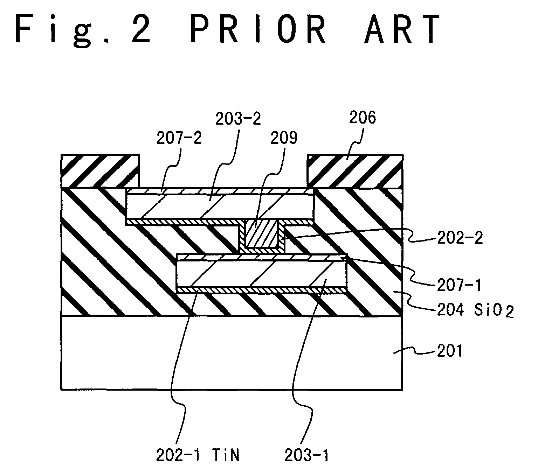

As a method of solving this problem, for example, a structure as shown in Fig. 2 is disclosed in Japanese Laid Open Patent Application (JP-A-Heisei 2-123740). According to this structure, TiN films 202 (202-1 and 202-2) are formed as a barrier film under the copper film and an Al film 207 is laminated on the surface of the copper wiring film 203. In Fig. 2, reference numeral 209 denotes a plug of material such as tungsten or the like with which a through-hole is filled.

According to this structure, since the Al film is formed on the surface of the copper wiring layer to have good bonding performance, the above problem does not occur. However, since this structure cannot be formed by the damascene method, an etching of the copper wiring film is very difficult. Also, this structure is inferior in the step coating performance and the flatness of the copper wiring film.

### Summary of the Invention

The present invention is accomplished in viewpoint of the above problems. Therefore, an object of the present invention is to provide a method of manufacturing a semiconductor device, in which a semiconductor device having good bonding performance in an assembling step is formed by using a copper wiring film by the damascene method which is excellent in the step coating performance and the flatness.

In order to achieve an aspect of the present invention, a method of manufacturing a semiconductor device, includes the steps of:
forming a copper wiring film in an interlayer insulating film by a damascene method;
forming a protective insulating film on the copper wiring film and the interlayer insulating film;
forming an opening in the protective insulating film; and
depositing an Al containing film on the protective insulating film to fill the opening.

The method may further include the step of patterning the Al containing film. Instead, the method may further include the step of performing a CMP (chemical mechanical polishing) method to the Al containing film to embed the Al containing film in the opening.

In the above, it is desirable that the Al containing film is selected from the group consisting of Al, Al-Si, and Al-Si-Cu. Also, when the copper wiring film is formed, a whole surface of the copper wiring film other than the opening is desirably surrounded by a film for preventing copper atoms from diffusing. In this case, the film for preventing copper atoms from diffusing is composed of a nitride film.

Also, when an opening is formed in the protective insulating film, a copper oxide is removed from the copper film by a dry etching method after the formation of the opening. At this time, O₂ plasma etching is performed using a diluted Hf gas and a H (hfac) gas.

The opening is an opening for an Al bonding pad.

In order to achieve another aspect of the present invention, a method of manufacturing a semiconductor device, includes the steps of:
forming a copper wiring film in an interlayer insulating film by a damascene method while surrounding a whole surface of the copper wiring film other than an upper surface by a film for preventing copper atoms from diffusing;
forming a protective insulating film on the copper wiring film and the interlayer insulating film;
forming an opening in the protective insulating film;
depositing an Al containing film on the protective insulating film to fill the opening; and
patterning the Al containing film to form a bonding pad.

In order to achieve still another aspect of the present invention, a method of manufacturing a semiconductor device, includes the steps of:
forming a copper wiring film in an interlayer insulating film by a damascene method while surrounding a whole surface of the copper wiring film other than an upper surface by a film for preventing copper atoms from diffusing;
forming a protective insulating film on the copper wiring film and the interlayer insulating film;
forming an opening in the protective insulating film;
depositing an Al containing film on the protective insulating film to fill the opening; and
performing a CMP (chemical mechanical polishing) method to the Al containing film to embed the Al containing film in the opening.

### Brief Description of the Drawings

Fig. 1 is a cross sectional view of a semiconductor device manufactured by a first conventional method;
Fig. 2 is a cross sectional view of a semiconductor device manufactured by a second conventional method;
Fig. 3 is a cross sectional view illustrating the structure of a semiconductor device manufactured by a manufacturing method according to a first embodiment of the present invention;
Figs. 4A to 4E are cross sectional views of the semiconductor device manufactured by a manufacturing method according to the first embodiment of the present invention; and
Fig. 5 is a cross sectional view illustrating the structure of a semiconductor device manufactured by a manufacturing method according to a second embodiment of the present invention.

### Description of the Preferred Embodiments

A method of manufacturing a semiconductor device of the present invention will now be described below in detail with reference to the attached drawings.

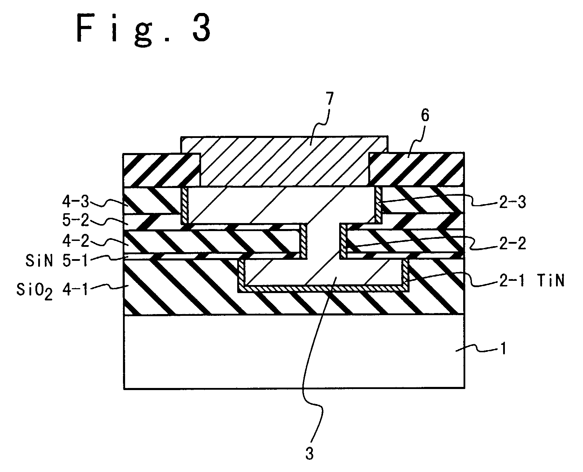

First, the manufacturing method according to the first embodiment of the present invention will now be described below. Fig. 3 shows the cross sectional view of the structure of the semiconductor device manufactured by the method according to the first embodiment of the present invention. In the first embodiment, the semiconductor device is formed to have a double layer wiring film. In an actual semiconductor device, although a device such as MOS transistor, bipolar transistor, or the like has been formed on the Si substrate 1, it is omitted on the drawing for simplicity of explanation.

Referring to Fig. 3, in a manner similar to the conventional manufacturing method described with reference to Fig. 1, the copper wiring film 3 is formed above the Si substrate 1 by the damascene method and a protective insulating film 6 is opened in order to form a bonding pad.

The Al film 7 is formed on the copper wiring film 3 in the opened bonding pad portion. The Al film has conventionally been widely used as a metal wiring film of semiconductor device. The Al film has a good fitness with the bonding wire of Au, Al, or the like, and it is hard to cause the problem on the defective bonding in the assembling step.

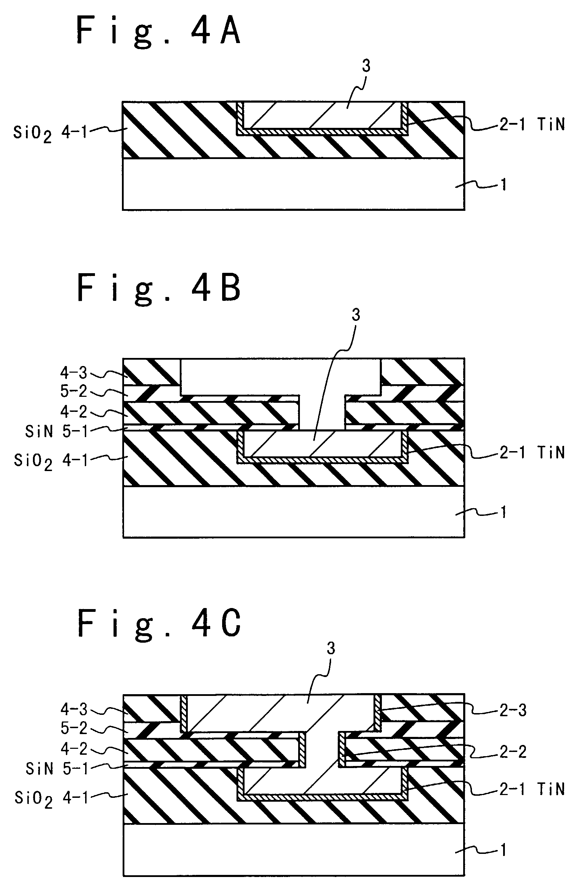

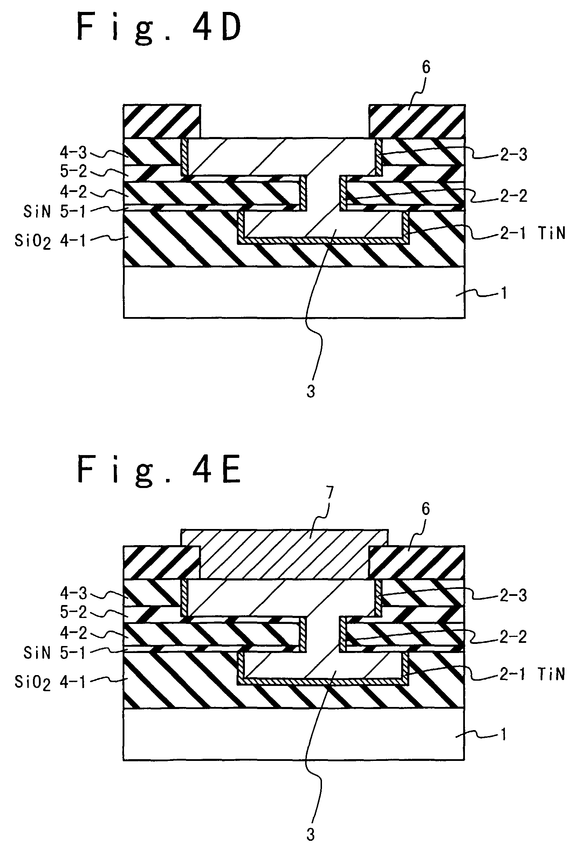

Figs. 4A to 4E are cross sectional views of the semiconductor device of Fig. 3 manufactured the method according to the first embodiment of the present invention in accordance with the order of manufacturing steps.

After devices such as a MOS transistor or the like (not shown) have been formed on the Si substrate 1, a SiO₂ insulating film 4-1 is formed as an interlayer film by the CVD process to have the film thickness of 1 µm A groove having the depth of 550 nm is formed in the insulating film 4-1 by using the lithography step and dry etching step. Although its explanation is omitted here, after that, a contact hole is formed to obtain an electrode of the device.

After the groove has been formed, a TiN nitride film 2-1 is formed to have the film thickness of 50 nm, and then a copper wiring film 3 having the film thickness of 500 nm is formed by a CVD method. The nitride film 2-1 is formed for the purpose of prevention of the diffusion of copper and the improvement of the fitness. The TiN nitride film 2-1 and the copper wiring film 3 are removed from the regions other than the wiring region by a CMP (Chemical Mechanical Polishing) method. As a result, the TiN nitride film 2-1 functions as a barrier film for copper atoms of the wiring film 3. Thus, the lower portion of the copper wiring film 3 is formed by by the damascene method.

Subsequently, as shown in Fig. 4B, a plurality of films are formed by the CVD processes. That is, a SiN nitride film 5-1 having a film thickness of 100 nm for the prevention of diffusion of copper atoms of the copper wiring film 3, and then a SiO₂ film 4-2 is formed as an interlayer insulating film to have the film thickness of 500 nm. Subsequently, a SiN nitride 5-2 having the film thickness of 300 nm is formed for prevention of diffusion of copper atoms of the copper wiring film 3 and then a SiO₂ film 4-3 is formed as an interlayer insulating film to have the film thickness of 500 nm. Thereafter, a groove having a depth of 700 nm is formed to reach the inside of the SiN nitride film 5-2. Then, a groove of 600 nm is formed as a viahole to connect to the first copper wiring film 3 which has been formed in the interlayer insulating film 4-1. The groove and the viahole are formed by the lithography step and dry etching step.

The groove and the viahole are subjected to the CVD process to deposite a TiN nitride film. An etching-back process is performed as an anisotropic etching process to form TiN nitride films 2-2 and 2-3 having the film thickness of 50 nm on only the side walls of the groove and viahole. The TiN nitride films 2-2 and 2-3 prevent the diffusion of copper atoms of the copper wiring film 3 to be formed later. At this time, a copper oxide film is formed on the surface of the first copper wiring film 3 exposed after the etching-back process. For this reason, the copper oxide film and deposition substances formed due to the etching are removed by O₂ plasma and a diluted HF gas and a H (hfac) gas.

Next, as shown in Fig. 4C, a copper film is formed by a CVD process to have the film thickness of 1.3 µm. Then, the copper film is removed by a CMP process from the regions other than the wiring region. Thus, the upper portion of the copper wiring films 3 is formed by the damascene method.

Next, a protective insulating films (a SiN nitride film in this example) 6 is formed by a CVD process to have the film thickness of 500 nm. Then, the patterning of the protective insulating film 6 is performed by a lithography step and a dry etching step to open a bonding pad portion in the protective insulating film 6.

At this time, a copper oxide film is formed on the surface of the upper portion of the copper wiring film 3 exposed in the etching for the opening of the bonding pad portion. The copper oxide film is removed by the O₂ plasma using a diluted HF gas and a H (hfac) gas.

Next, as shown in Fig. 4E, an Al film is deposited by a sputtering method to have the film thickness of 1 µm. The Al film is patterned by the lithography step and etching step to form an Al film 7 covering the bonding pad portion.

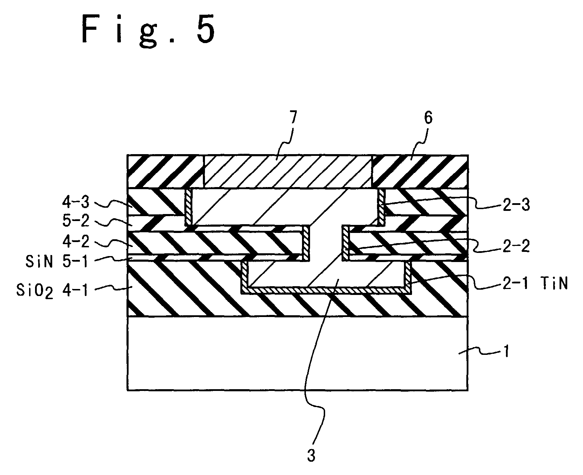

Next, the method of manufacturing a semiconductor device according to the second embodiment of the present invention. Fig. 5 is a cross sectional diagram illustrating the structure of the semiconductor device manufactured by the method according to the second embodiment of the present invention. Referring to Fig. 5, in the semiconductor device in the second embodiment, the Al film 7 is also formed by the damascene method.

The semiconductor device manufacturing method in the second embodiment is the same as that of the first embodiment in Figs. 4A to 4D. After that, the Al film is deposited by the sputtering method to have the film thickness of 1 µm. The Al film is subjected to the CMP process such that the Al film is left in only the bonding pad portion. Thus, the embedded Al film 7 is formed.

According to this method, as compared with the first embodiment, since the lithography step is not used, the processing steps are simplified.

The embodiments have been described with respect to the cases using the Al film. However, the present invention can be also obviously applied to a case of using another Al containing film such as AlSi and Al-Si-Cu in place of the Al film.

According to a manufacturing method of a semiconductor device of the present invention, the copper wiring film is formed by the damascene method and a protective insulating film is opened. Then, only the bonding pad portion is coated by the Al containing film.

As described above, in the present invention, a copper wiring film is formed by the damascene method, and the protective insulating film is formed. Then, the bonding pad portion is formed through the protective insulating film. Thus, the copper wiring film surface is exposed. The Al containing film is deposited and then the CMP step or the lithography step and etching step are performed so that the Al containing film is left in only the bonding pad portion. Therefore, the problem on the fitness between the bonding wire and the bonding pad at the time of assembling is eliminated, because the Al film has good bonding performance.

Also, in the manufacturing method of the semiconductor device of the present invention, since the copper wiring film is formed by the damascene method, the wiring having good step coating performance and flatness can be formed.

Further, in the manufacturing method of the semiconductor device of the present invention, the copper wiring film is surrounded by the copper atom diffusion preventing film formed of the nitride films such as the SiN film and the TiN film.

As described above, according to the present invention, since the bonding pad portion of the semiconductor device on which the copper wiring film has been formed is covered by the Al film having good bonding performance, the problem about the fitness between the bonding wire and the bonding pad in the assembling step hardly occurs, so that the reliability and yield are improved.

Also, since the copper wiring film can be formed by the damascene method, the wiring having the good step coating performance and flatness can be formed.

## Claims

1. A method of manufacturing a semiconductor device, comprising the steps of:
forming a copper wiring film in an interlayer insulating film by a damascene method;
forming a protective insulating film on said copper wiring film and said interlayer insulating film;
forming an opening in said protective insulating film; and
depositing an Al containing film on said protective insulating film to fill said opening.

2. A method according to claim 1, further comprising the step of patterning said Al containing film.

3. A method according to claim 1, further comprising the step of performing a CMP (chemical mechanical polishing) method to said Al containing film to embed said Al containing film in said opening.

4. A method according to any one of claims 1 to 3, wherein said Al containing film is selected from the group consisting of Al, Al-Si, and Al-Si-Cu.

5. A method according to any one of claims 1 to 4, wherein said step of forming a copper wiring film further includes surrounding a whole surface of said copper wiring film other than said opening by a film for preventing copper atoms from diffusing.

6. A method according to claim 5, wherein said film for preventing copper atoms from diffusing is composed of a nitride film.

7. A method according to any one of claims 1 to 6, wherein said step of forming an opening in said protective insulating film further includes removing a copper oxide from said copper film by a dry etching method after the formation of said opening.

8. A method according to claim 7, wherein said dry etching is O₂ plasma etching using a diluted Hf gas and a H (hfac) gas.

9. A method according to any one of claims 1 to 8, wherein said opening is an opening for an Al bonding pad.
